(19) Europäisches Patentamt
European Patent Office
Office européen des brevets

(11) Veröffentlichungsnummer: **0 039 417**
**A1**

(12) # EUROPÄISCHE PATENTANMELDUNG

(21) Anmeldenummer: **81102605.3**

(22) Anmeldetag: **07.04.81**

(51) Int. Cl.³: **C 01 B 33/02**

(30) Priorität: **02.05.80 DE 3016807**

(43) Veröffentlichungstag der Anmeldung: **11.11.81**
**Patentblatt 81/45**

(84) Benannte Vertragsstaaten: **AT BE CH FR GB IT LI NL SE**

(71) Anmelder: **Licentia Patent-Verwaltungs-GmbH,**
**Theodor-Stern-Kai 1, D-6000 Frankfurt/Main 70 (DE)**

(72) Erfinder: **Dahlberg, Reinhard, Dr., Innere Bergstrasse 32,**
**D-7101 Flein (DE)**

(74) Vertreter: **Maute, Hans-Jürgen, Dipl.-Ing. et al, Licentia**
**Patent-Verwaltungs-GmbH Theodor-Stern-Kai 1,**
**D-6000 Frankfurt/Main 70 (DE)**

(54) **Verfahren zur Herstellung von Silizium.**

(57) Es wird ein kostengünstiges Verfahren zur Herstellung von reinem Silizium beschrieben, bei welchem die Reduktion einer Siliziumverbindung zu elementarem Silizium in der Plasma-Zone eines Gas-Stromes erfolgt. Das erzeugte Silizium, das in diesem Prozeß auch gleichzeitig dotiert werden kann, wird auf einem Substrat als einkristalline oder polikristalline Schicht oder als Pulver abgeschieden. Das Verfahren ist besonders geeignet zur Herstellung kostengünstiger Silizium-Solarzellen.

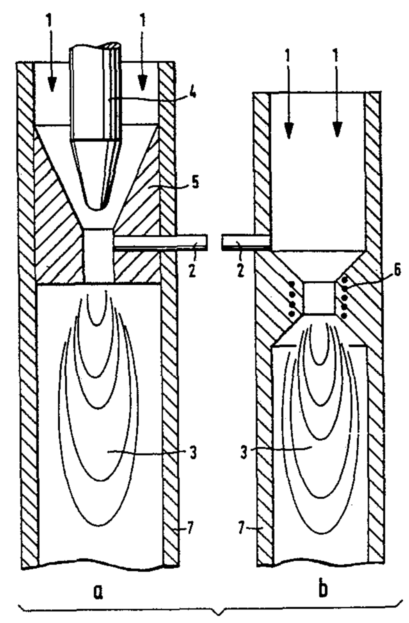


EP 0 039 417 A1

0039417

Licentia Patent-Verwaltungs-G.m.b.H.
Theodor-Stern-Kai 1, 6000 Frankfurt 70

Heilbronn, den 10.02.81
SE2-HN-Ma/goe

# Verfahren zur Herstellung von Silizium

Das Element Silizium wird in beträchtlichem Umfang als Legierungszusatz in der Metallurgie und in sehr reiner Form in steigenden Mengen in der Halbleiterindustrie verbraucht. Der Bedarf an Silizium für die Herstellung von Solarzellen für die direkte Nutzung von Sonnenenergie wird in Zukunft stark ansteigen.

Nach dem Sauerstoff ist Silizium das in der Erdkruste am häufigsten vorkommende Element. Es ist - gebunden im Quarz, in Silikaten, aber auch in vielen anderen Mineralien - praktisch überall vorhanden.

Zur technischen Darstellung von Silizium geht man etwa von Quarzsand aus, der durch Kohle oder durch Metalle wie Aluminium, Magnesium oder Natrium zu Silizium reduziert werden kann. Für die Halbleiterindustrie wird dieses Roh-Silizium gereinigt und z. B. mit Hilfe von Chlorgas bei erhöhter Temperatur zu $SiCl_4$ umgesetzt. $SiCl_4$ gestattet eine weitere Reinigung durch fraktionierte Destillation.

Durch Pyrolyse, d. h. durch Zersetzen z. B. eines Gemisches von $H_2$ und $SiCl_4$, etwa an einem heißen Silizium-Stab, läßt sich elementares Silizium sehr rein in polikristalliner Form

gewinnen. Durch sog. "Zonen-Ziehen" oder "Tiegel-Ziehen" kann das polikristalline Silizium in einkristalline Stäbe umgewandelt werden. "Dotierte", d. h. mit gezielten Verunreinigungen versehene Silizium-Einkristallstäbe werden zu Scheiben zersägt.
Diese sind das wichtigste Ausgangsmaterial für die Halbleiter-Industrie. Für Silizium-Solarzellen können auch polikristalline Silizium-Scheiben verwendet werden, deren Herstellkosten wesentlich geringer sind als die Herstellkosten von Einkristall-Scheiben.

Noch geringere Herstellkosten lassen Silizium-Solarzellen erwarten, bei denen nur ein dünner Silizium-Film auf einem geeigneten Träger etwa durch pyrolytisches Zersetzen einer geeigneten Siliziumverbindung wie z. B. $SiH_4$ erzeugt wird.

Alle bekannten Verfahren zur Herstellung von Silizium, Siliziumscheiben oder Siliziumschichten haben speziell im Hinblick auf die Herstellung von billigen Solarzellen mit hohem Wirkungsgrad noch zwei Nachteile:

1. Silizium-Scheiben oder -Schichten aus hinreichend reinem Silizium mit guter Kristallqualität sind noch relativ teuer und

2. hinreichend billige Scheiben oder Schichten aus Silizium sind in ihrer Qualität meist nicht ausreichend für gute Solarzellen.

Diese Nachteile entstehen einmal dadurch, daß nach der Reduktion des Siliziums zu viele Folgeschritte der Verarbeitung bis zur Silizium-Scheibe oder -Schicht nötig sind. Zum anderen sind aber auch die Prozesse der Reinigung und Reduktion des polikristallinen Siliziums relativ aufwendige Prozesse. Flüssiges Silizium ist darüberhinaus ein Material, das einen hohen Energie- und Material

Aufwand erfordert und welches durch praktisch alle Materialien, mit denen es bei hoher Temperatur mechanischen Kontakt hat (wie z. B. Tiegel- oder Substrat-Materialien) verunreinigt wird.

Die vorliegende Erfindung hat das Ziel, reines Silizium zu niedrigsten Kosten zu erzeugen. Sie löst diese Aufgabe dadurch, daß ein Gas-Strom vorgesehen ist, daß in diesem Gas-Strom ein Plasma erzeugt wird, daß Mittel vorgesehen sind, durch welche der Gas-Strom mindestens mit einer Silizium-Verbindung beladen wird, daß im Plasma des Gas-Stromes die Siliziumverbindung zu Silizium zerlegt oder reduziert wird, und daß das Silizium zusammen mit den Reaktionsprodukten durch den Gas-Strom aus dem Plasma heraustransportiert wird.

Das durch den Gas-Strom wegtransportierte Silizium kann auf einem Substrat als zusammenhängende Schicht oder als massiver Kristall niedergeschlagen oder abgeschieden werden. Es kann jedoch auch als Pulver kondensieren und abgeschieden werden.

Ein Plasma läßt sich in einem Gas-Strom z. B. dadurch erzeugen, daß in den Gas-Strom zwischen gekühlten Elektroden ein elektrischer Lichtbogen brennt. Dadurch entsteht ein Lichtbogen-Plasma im Gas-Strom. Das elektrische Plasma im Gas-Strom kann jedoch auch dadurch erzeugt sein, daß ein geeignetes elektro-magnetisches Wechselfeld an den Gas-Strom angelegt ist. Wenn der Gas-Strom z. B. durch den von einer Hochfrequenz-Spule umschlossenen Raum geführt wird, kann ein Induktions-Plasma im Gas-Strom erzeugt werden. Auch durch Absorption von elektromagnetischer Strahlung hoher Intensität, z. B. LASER-Strahlung, oder von sehr intensiver ionisierender Strahlung z. B. $\alpha$- oder $\beta$-Strahlung kann im Gas-Strom ein Plasma erzeugt werden.

Besonders einfach und bequem läßt sich das Verfahren zur Herstellung von Silizium gemäß der Erfindung technisch durchführen, wenn dafür eine sog. Plasma-Spritz-Anlage (auch Plasma-Flamm-, Plasma-Spray-, Plasma-Jet- oder Plasma-Pulver-Schweiß-Anlage genannt) eingesetzt wird. Derartige Anlagen für das Plasma-Spritzen und Plasma-Auftragsschweißen von metallischen und keramischen Materialien sind auf dem Markt erhältlich. Bei einer Plasma-Spritz-Anlage mit "Gas-stabilisiertem" Plasma wird in einer Kammer zwischen einer z. B. thorierten Wolfram-Kathode und einer wassergekühlten Düse als Anode ein Gleichstrom-Lichtbogen erzeugt, der durch einen Gas-Strom - z. B. aus $H_2$-Gas - durch die Düse hindurchgetrieben wird. Der äußere schnelle Gasmantel des Gas-Stromes hält den Lichtbogen von der gekühlten Düsenwand fern, während das zentrale langsame Wasserstoffgas in Plasma umgewandelt wird. In steigender Entfernung von der Kathode wird der langsamer fließende Plasma-Kern des Gas-Stromes mit dem äußeren schnellen Gasmantel vermischt und durch den sich in der Richtung umkehrenden Lichtbogen zusätzlich erhitzt, so daß sich der gesamte Gas-Strom aufheizt und ein verlängertes Plasma bildet. Im Plasma werden Temperaturen bis 30 000 °C erreicht. Bläst man ein Metall- oder Keramik-Pulver in den Gas-Strom, dann wird dieses weit über seinen Schmelzpunkt erhitzt und mit hoher Geschwindigkeit (z. B. einigen 100 Metern pro Sekunde) auf ein Werkstück aufgetragen.

Beim Plasma-Pulver-Auftragsschweißen brennt ein eingeschnürter Lichtbogen zwischen einer wassergekühlten Elektrode und dem zu beschichtenden Werkstück. Das aufzutragende Pulver wird in genau dosierten Mengen dem Lichtbogen zugeführt und in die Oberfläche des Werkstückes eingeschmolzen. Extreme elektrische Leistungen werden bei Verwendung von Plasma-Spritz-Anlagen mit "Wasser-stabilisiertem" Plasma erzielt. Die Stabilisierung und Einschnürung des Lichtbogens erfolgt dabei durch Wasser. Der Gas-Strom besteht aus Wasser-Plasma

welches der Lichtbogen aus Wasser selbst erzeugt.

Plasma-Spritz-Anlagen der geschilderten Art lassen sich direkt oder nach relativ geringfügiger Modifizierung zur Herstellung von Silizium gemäß der Erfindung verwenden.

Durch das US-Patent No 4,003,770 vom 18. Januar 1977 ist es bereits bekannt, p- oder n-dotierte Silizium-Teilchen durch Injektion in einem Plasma-Strahl aufzuheizen und auf einem Substrat als polikristallinen Film niederzuschlagen. Das Silizium wird dabei aber bereits in elementrarer und dotierter Form dem Plasma-Strahl zugeführt. Eine Erzeugung von elementarem Silizium durch Zerlegung oder Reduktion einer Siliziumverbindung im Plasma ist in diesem Patent nicht offenbart.

Der Gas-Strom durch den Lichtbogen einer Plasma-Spritz-Anlage besteht erfindungsgemäß vorzugsweise aus Wasserstoff, Edelgas, Stickstoff, Halogen, Kohlenwasserstoff, Kohlenmonoxid, Wasserdampf oder einer Mischung oder Verbindung dieser Gase.

Die Siliziumverbindung, mit welcher der Gas-Strom beladen ist, kann eine Sauerstoff-freie Verbindung sein, wie z. B. $SiH_4$, $SiCl_4$, $SiHCl_3$, $SiH_2Cl_2$ oder eine andere Wasserstoff-, Halogen- oder Wasserstoff-Halogen-Verbindung.

Sie kann aber auch eine Sauerstoff-haltige Verbindung des Siliziums sein wie z. B. $SiO_2$, ein Silikat oder eine organische oder Silizium-organische Verbindung. Bei Temperaturen über 2000 °C wird $SiO_2$ durch Wasserstoff zu Silizium reduziert.

Zusätzlich zur Silizium-Verbindung kann dem Gas-Strom auch ein Dotierstoff für Silizium z. B. aus der dritten oder fünften Gruppe des Periodischen Systems der Elemente beigemischt werden. Durch Beimischung von B, Al, Ga, In oder von Beryllium oder auch von chemischer Verbindungen

dieser Elemente wie z. B. $B_2H_6$, $AlCl_3$ usw. in definierter Menge läßt sich das Silizium p-dotiert abscheiden.

Definierte Beimischungen von P, As, Sb oder von Vanadium oder auch von Verbindungen dieser Elemente wie z. B. $PH_3$, $AsCl_3$, $VCl_4$ usw. ermöglichen es, das Silizium n-dotiert abzuschneiden.

Der Gas-Strom kann erfindungsgemäß auch zusätzlich noch mit Silizium-Pulverteilchen beladen sein, um z. B. die Keimbildungsgeschwindigkeit für das reduzierte Silizium oder die niedergeschlagene Silizium-Menge zu erhöhen.

Der Gas-Strom kann aber zusätzlich auch mit Kohlenstoff-Pulverteilchen beladen sein, um z. B. die reduzierende Wirkung des Gas-Stromes zu erhöhen.

In einem bevorzugten Ausführungsbeispiel der Erfindung besteht der Gas-Strom aus Wasserstoff und die Siliziumverbindung aus Siliziumtetrachlorid, oder einem Halogensilan.

In einem anderen bevorzugten Ausführungsbeispiel besteht der Gas-Strom aus Edelgas oder Wasserstoff und als Siliziumverbindung wird Siliziumwasserstoff (Silan wie. z. B. $SiH_4$, $Si_2H_6$ usw.) verwendet.

In einem weiteren bevorzugten Ausführungsbeispiel besteht der Gas-Strom aus Wasserstoff und die Siliziumverbindung ist $SiO_2$ z. B. in Pulverform.

Der Gas-Strom kann jedoch erfindungsgemäß auch aus einem Gemisch von Edelgas mit einer Kohlenwasserstoffverbindung oder aus einem Gemisch von Wasserstoff mit einer Kohlenwasserstoffverbindung bestehen, während die Siliziumverbindung $SiO_2$-Pulver oder Silikat-Pulver ist. Dem $SiO_2$-Pulver oder dem Silikat-Pulver können zusätzlich auch noch Kohlenstoff-Pulverteilchen beigemengt werden.

Der Gas-Strom kann aber auch aus Edlegas, Stickstoff oder Kohlenstoff-Monoxid bestehen, und der Silizium-verbindung (z. B. $SiO_2$ oder ein Silikat) können andere Chemikalien (wie z. B. ein Metallpulver) beigefügt sein.

Das gemäß der Erfindung hergestellte Silizium kann auf einer einkristallinen Silizium-Oberfläche abgeschieden oder niedergeschlagen sein. Wenn die Temperatur der Silizium-Oberfläche hoch genug ist, kann das abgeschiedene oder niedergeschlagene Silizium einkristallin aufwachsen.

Das Silizium kann jedoch auch auf einer metallisch leitenden Fläche, wie z. B. auf einer Metall-Oberfläche oder auf einer metallisch leitenden Schicht abgeschieden oder niedergeschlagen sein.

Auch auf einer Isolator-Fläche z. B. auf Keramik, Glas oder organischem Material läßt sich das Silizium auftragen. Da das Plasma sehr schnell abkühlt lassen sich für das Niederschlagen oder Abschneiden des Siliziums Bedingungen einstellen, bei denen die Auffangfläche nicht über 200 °C erhitzt wird.

Das Silizium läßt sich erfindungsgemäß auch auf einer Flüssigkeits-Oberfläche niederschlagen, die mit dem Silizium chemisch nicht reagiert, wie z. B. auf flüssigem $MgCl_2$ oder Blei bei etwa 750 °C.

Auch auf einem erhitzten Träger (wie z. B. Graphit bei 1000 °C), der mit einem Flüssigkeitsfilm (z. B. von NaF) überzogen ist, läßt sich das Silizium abscheiden. Man erhält dabei Silizium-Schichten, die in größeren Bereichen

einkristallin sind.

In einem bevorzugten Ausführungsbeispiel wird das Silizium auf einer metallisch leitenden Flüssigkeitsoberfläche oder auf einem metallisch leitenden Flüssigkeitsfilm niedergeschlagen. Als Metalle, die mit dem Silizium auch in flüssiger Phase nicht reagieren, eignen sich besonders Zinn, Blei, Zink, Wismut, Cadmium, Thallium, Quecksilber Gallium, Indium und Antimon sowie Mischungen dieser Elemente.

Beim Abscheiden des Siliziums auf einem Substrat, welches sich in einer Sauerstoff-freien Atmosphäre befindet, erhält man Oxid-freies Silizium.

Es ist erfindungsgemäß auch vorteilhaft, das Plasma und den Gas-Strom in einen Raum mit starkem Unterdruck oder ins Vakuum zu blasen. Dabei lassen sich Gasgeschwindigkeiten bis zu einem Mehrfachen der Schallgeschwindigkeit erreichen. Eine Abscheidung des Siliziums gemäß der Erfindung im Sauerstoff-freien Vakuum ergibt Oxid-freies kompaktes Silizium von besonders guter Kristallqualität.

Das Verfahren gemäß der Erfindung eignet sich zur kostengünstigen Herstellung von einkristallinem und polikristallinem Silizium.

Es kann darüber hinaus zu direkten Herstellung von einkristallinen oder polikristallinen Silizium-Platten, -Scheiben oder -Schichten benutzt werden, die ohne jeden Zwischenschritt, direkt im Herstellungsprozeß des Siliziums gemäß der Erfindung erzeugt werden.

Das Verfahren ist deshalb auch besonders gut geeignet zur Herstellung von Silizium-Solarzellen und von Silizium-Bauelementen.

Sowohl die n-Zone als auch die p-Zone und der p/n-Übergang eines Bauelementes oder einer Solarzelle lassen sich nach dem Verfahren der Erfindung dadurch erzeugen, daß eine entsprechende Beladung des Gas-Stromes mit Dotierungsmaterial erfolgt. P/n-Strukturen können dabei in einem kontinuierlichen Abscheidungsvorgang erzeugt werden. P/n-Übergänge können jedoch auch in zwei getrennten Abscheidungsvorgängen erzeugt sein. Die Solarzelle kann jedoch auch mit einem Hetero-Übergang (z. B. eine $SnO_2$-Schicht oder $SnO_2$ + $In_2O_3$-Schicht auf n- oder p-Silizium) oder einem Schottky-Übergang zur Ladungstrennung ausgebildet sein. Auch ihre Herstellung als SIS-Struktur oder MIS-Struktur ist in an sich bekannter Weise möglich.

Mit Hilfe einer geeigneten Prozeßführung (entsprechender Abstand zwischen Lichtbogen und Auffangfläche) läßt sich mit dem Verfahren gemäß der Erfindung auch Silizium-Pulver herstellen.

Entsprechend einer Weiterbildung der Erfingung läßt sich das in der Lichtbogenzone erzeugte Silizium noch im Gas-Strom zur Bildung eines Silizids verwenden, das dann anstelle des Siliziums abgeschieden wird.

Siliziumcarbid, Siliziumnitrid und Metallsilizide lassen sich in Form von kompakten Kristallen, Platten, Scheiben oder Schichten oder aber auch in Form von Pulver erzeugen.

Das Verfahren zur Herstellung von Silizium gestattet die Herstellung von reinem Silizium, dessen Reinheitsgrad ausschließlich vom Reinheitsgrad der verwendeten Gase und Chemikalien abhängt. Eine Verunreinigung im Herstellprozeß erfolgt nicht.
Es ist in besonderem Maße kostengünstig, weil die im Endeffekt gewünschte Form des reinen Siliziums (Platte, Scheibe oder Schicht) in einem einzigen Hochtemperaturprozeß erzeugt wird: Reduktion im Plasma mit direkt nachfolgender gezielter Abscheidung auf einem beliebigen Substrat.

Vor allem bei Verwendung von pulverförmigen Silizium-Verbindungen mit relativ grober Körnung kann es vorkommen, daß die Pulverkörner die Hochtemperatur-Zone des Plasmas so schnell passieren, daß keine hinreichend hohe Erhitzung der Pulverkörner erfolgt. Dies ist vor allem bei der Reduzierung von Quarzpulver im Plasma kritisch, weil hinreichend feinkörniges Silizium-Oxid-Pulver sich nur mit großen Schwierigkeiten in den Gas-Strom hinreichend gleichmäßig einspeisen läßt.
Gemäß einer Weiterbildung der Erfindung wird diese Schwierigkeit bei der Reduzierung von Silizium-Oxid im Plasma eines Gas-Stromes beseitigt. Dies geschieht dadurch, daß ein Plasma in einem nichtoxidierenden Gas-Strahl vorgesehen ist, daß in das Plasma ein Formkörper teilweise eineingebracht ist, daß der Formkörper aus Silizium-Oxid besteht oder Silizium-Oxid enthält, daß im Plasma das Silizium-Oxid zu Silizium reduziert wird, und daß das erzeugte Silizium im Gas-Strahl wegtransportiert wird.

Ein wesentlicher Vortei dieser Weiterbildung der Erfindung besteht darin, daß das Silizium-Oxid erheblich länger in der Hochtemperaturzone des Plasmas verweilen kann, so daß es sich hinreichend hoch erhitzt.

Das Silizium-Oxid kann z. B. in Form eines Quarz-Stabes eines Quarz-Fadens oder eines Quarz-Rohres in das Plasma

eingeführt werden. Das eingeführte Ende verdampft im Plasma und der Stab, der Faden oder das Rohr wird so nachgeführt, daß ein kontinuierlicher Prozeß entsteht.

Das Silizium-Oxid kann aber auch in Form eines gepreßten oder gesinterten Stabes aus SiO- oder $SiO_2$-Pulver in das Plasma eingeführt werden.

Es kann jedoch auch als Formkörper aus einem Gemisch von Kohlenstoff oder einer Kohlenstoffverbindung mit Silizium-Oxid in das Plasma eingebracht werden.

In der Hochtemperatur-Zone des Plasmas reagiert dann der Kohlenstoff mit dem Quarz z. B. gemäß der Gleichung

$$SiO_2 + 2C = Si + 2\,CO$$

oder bei Verwendung einer gesättigten Kohlenwasserstoffverbindung vom Typus $C_nH_{2n+2}$ im Gemisch mit $SiO_2$ reagiert dieses im Plasma gemäß der Gleichung

$$\frac{2n+1}{2}\ SiO_2 + C_nH_{2n+2} = \frac{2n+1}{2}\ Si + nCO + (n+1)\ H_2O$$

Diese Reaktionen laufen auch dann im Plasma ab, wenn der Gas-Strom aus Inert-Gas wie z. B. Edelgas oder Stickstoff besteht. Auch das Wasser-Plasma $2\,H^+ + O^{--}$ verhält sich dabei wie ein Inert-Gas.

Zur Dotierung des im Plasma durch Reduktion erzeugten Siliziums, kann dem Silizium-Oxid eine kleine Menge eines Elementes oder einer Verbindung eines Elementes aus der dritten oder fünften Gruppe des Periodischen Systems beigemengt sein.

Für die Erzeugung des Plasmas in einem nichtoxidierenden Gas-Strahl kann vorteilhafterweise eine Gas-stabilisierte Plasma-Spritz-Anlage oder eine Plasma Schweiß-Anlage benutzt werden. Da die Elektroden einer derartigen Anlage einem Verschleiß unterworfen sind, durch welchen das erzeugte Silizium verunreinigt wird, ist es zweckmäßig, mindestens die Kathode der Plasma-Anlage aus Silizium zu fertigen.

Bei Verwendung einer Wasser-stabilisierten Plasma-Spritz-Anlage mit rotierender Anode lassen sich in der Zeiteinheit erheblich größere Silizium-Mengen erzeugen. Auch hier ist es vorteilhaft, anstelle der meistens verwendeten Graphit-Kathode eine Kathode aus Silizium zu verwenden.

Wenn die Anode (z. B. eine zylinderförmige Rotations-Anode) ebenso wie die Kathode aus dotiertem Silizium besteht, dann entsteht durch den unvermeidbaren Abbrand der Elektroden keine untragbare Verunreinigung, wenn der Leitfähigkeitstyp vom Silizium der Elektroden gleich dem Leitfähigkeitstyp des erzeugten Siliziums ist. Verwendet man entsprechend hoch dotiertes Silizium für die Elektroden, dann läßt sich durch den Abbrand eine gezielte Dotierung des erzeugten Siliziums bewirken.

Als Gase für den nichtoxidierenden Gas-Strahl, in welchem das Plasma erzeugt ist, eignen sich auch hier z. B. alle Edelgase, Wasserstoff, Stickstoff, Kohlenoxid. Kohlenwasserstoffe, Halogenwasserstoffe, Schwefelwasserstoff, Ammoniak, Wasserdampf und andere sowie Gemische dieser Gase.

Um das erzeugte Silizium vor Oxidation durch den Luft-Sauerstoff zu schützen, kann man den Gas-Strahl mit dem Plasma in einen brennenden Mantel aus z. B. Kohlenwasserstoff- oder Wasserstoff-Gas einhüller.

Auch durch einen nichtbrennenden Mantel aus z. B. Edelgas oder Stickstoff kann der Luft-Sauerstoff weitgehend ferngehalten werden. Noch zuverlässiger wird das erzeugte Silizium gegen Oxidation geschützt, wenn sich der Gas-Strahl mit dem Plasma in einer Kammer mit einer Sauerstoff-freien Atmosphäre befindet.

Es kann auch zweckmäßig sein, den Gas-Strahl mit dem Plasma in eine Sauerstoff-freie Unterdruck-Kammer einströmen zu lassen. Dabei ist ein besonders wirkungsvolles Ausfrieren des Wasserdampf-Partialdruckes mit Hilfe einer Tiefkühl-Falle möglich.

Bei der Reduktion des Silizium-Oxids im Plasma entsteht zunächst Silizium in Dampf-Form, welches sich außerhalb des Plasmas als Silizium-Schicht auf einem Substrat niederschlagen läßt. Wenn das Substrat selbst aus einkristallinem Silizium besteht, dann lassen sich auf diese Weise einkristalline Silizium-Schichten herstellen, wenn die Temperatur des Substrates hoch genug ist. Da sich auf beliebigen Substraten wie Metall, metallisierte Keramik oder Glas polikristalline Silizium-Schichten direkt aus Silizium-Oxid erzeugen lassen, eignet sich das beschriebene Verfahren besonders zur kostengünstigen Herstellung von fotovoltaischen Solarzellen aus Silizium.

Im folgenden soll die Erfindung anhand von 11 Ausführungsbeispielen näher erläutert werden.

Ausführungsbeispiel 1 gibt das Prinzip der erfindungsgemäßen Herstellung von Silizium mit Lichtbogen-Plasma und mit Induktions-Plasma wieder.

Ausführungsbeispiel 2 beschreibt die Herstellung von Silizium durch Zerlegung von $SiH_4$ in einem Induktions-Plasma und die Abscheidung des Siliziums als einkristalline Schicht.

Ausführungsbeispiel 3 zeigt die Reduktion von Siliziumtetrachlorid in einem durch einen elektrischen Gleichstrom erzeugten Plasma zur Herstellung einer Silizium-Scheibe.

Ausführungsbeispiel 4 beschreibt die Reduktion von $SiO_2$ in einem Lichtbogen-Plasma zur Herstellung einer polikristallinen Silizium-Schicht auf einem Eisen-Substrat.

Ausführungsbeispiel 5 beschreibt die Plasma-Reduktion von $SiO_2$ zur Herstellung eines Siliziumbandes.

Ausführungsbeispiel 6 gibt im Querschnitt die Struktur einer Silizium-Solarzelle wieder, deren Siliziumschichten nach dem Verfahren der Erfindung erzeugt sind.

Ausführungsbeispiel 7 beschreibt die Herstellung von Silizium-Pulver durch Reduktion von Quarzsand mit Methan im Plasma.

Ausführungbeispiel 8 gibt die Herstellung von Siliziumcarbidschichten wieder, die aus der Reaktion von im Plasma erzeugten Silizium mit Kohlenstoff gebildet werden.

Ausführungsbeispiel 9 beschreibt die Erzeugung einer Schicht aus Molybdänsilizid, welches durch die Reaktion von im Plasma erzeugtem Silizium mit Molybdän gebildet wird.

Ausführungsbeispiel 10 zeigt eine Gas-stabilisierte Plasma-Schweiß-Anlage, bei der ein Quarz-Stab teilweise in das Plasma eingeführt ist. Das verdampfte und reduzierte $SiO_2$ wird als Silizium-Film auf einem metallischen Substrat, welches gleichzeitig die Anode ist, niedergeschlagen.

Ausführungsbeispiel 11 zeigt eine wasserstabilisierte Plasma-Spritz-Anlage, bei der ein Stab aus gepreßtem Silizium-Oxid-Pulver teilweise in das Plasma eingeführt ist und welche sich in einer Kammer mit Sauerstoff-freier

Atmosphäre befindet.

Ausführungsbeispiel 1

In Fig 1 bedeutet 1 einen Gas-Strom, welcher mit einer Siliziumverbindung 2 beladen ist. Mit Hilfe eines elektrischen Gleichstromes (a) - zwischen der Kathode 4 und der Anode 5 - oder mit Hilfe eines elektrischen Wechselstromes (b) - induziert über die Hochfrequenz-Spule 6- wird der Gas-Strom 1 aufgeheizt und in Plasma 3 verwandelt. Die Siliziumverbindung 2 wird im Plasma 3 in elementares Silizium zerlegt oder reduziert. 7 ist das Gehäuse der Anordnung.

Ausführungsbeispiel 2

In Fig 2 ist 3 eine Plasma-Zone, welche durch Hochfrequenz-Erhitzung eines Argon-Gas-Strahles erzeugt wird. Der Argon-Gas-Strahl ist mit Silan beladen, welches im Plasma 3 in elementares Silizium zerlegt wird:

$$SiH_4 + Ar = Si + 2H_2 + Ar$$

Dem $SiH_4$ ist noch eine geringe Menge Phosphorwasserstoff beigegeben, so daß sich das im Plasma 3 gebildete Silizium auf dem Substrat 9 als n-Silizium-Schicht 10 niederschlägt. Das Substrat 9 ist eine einkristalline Silizium-Scheibe, welche eine Temperatur von 900 °C hat und sich im Vakuum 8 befindet. Die niedergeschlagene n-leitende Silizium-Schicht 10 ist deshalb ebenfalls einkristallin.

Ausführungsbeispiel 3

In Fig 3 ist das Plasma 3 durch einen Gleichstromlichtbogen in einem Wasserstoff-Strom erzeugt. Der Wasserstoff-Strom ist mit Siliziumtetrachlorid beladen, so daß im Plasma 3 die Reaktion abläuft:

$$2\ H_2 + SiCl_4 = Si + 4\ HCl$$

Dem $SiCl_4$ ist eine geringe Dosis $BCl_3$ beigemischt. Das Substrat 9 ist eine Kohle-Platte, die im Vakuum 8 durch die Heizung 13 auf eine Temperatur von 1000 °C aufgeheizt ist. Sie ist an ihrer Oberfläche mit einem flüssigen Film 12 aus Natriumfluorid überzogen. Das im Plasma 3 reduzierte Silizium wird als p-leitende sehr grob kristalline Schicht 11 auf dem NaF-Flüssigkeits-Film 12 niedergeschlagen.

Ausführungsbeispiel 4

In Fig 4 brennt in einem Wasserstoff-Strom das Plasma 3. Der Wasserstoff-Strom ist mit einem Gemisch aus Quarzmehl mit p-dotiertem Siliziumpulver beladen. Im Plasma läuft die Reaktion ab:

$$SiO_2 + 3\ H_2 + Si = 2\ Si + H_2O + H_2$$

Auf einem Eisenblech 9, welches mit einer Aluminium-Schicht 14 überzogen ist, wird die p-Silizium-Schicht 11 im Vakuum 8 abgeschieden.

Ausführungsbeispiel 5

In Fig 5 wird der Kopf einer Plasma-Spritzanlage 16 von Argon-Gas 1 durchströmt. Dieser Gas-Strom 1 wird mit

einem Pulvergemisch 2 aus $SiO_2$-Pulver mit sehr geringem $B_2O_3$-Anteil und Graphit-Pulver beladen. Zwischen der Kathode 4 und der Anode 5 brennt im Argon-Gas-Strom 1 ein Lichtbogen, der das Plasma 3 erzeugt. Kathode 4 und Anode 5 sind wassergekühlt 17. Im Plasma 3 erfolgt die Reduktion des $SiO_2$ nach der Gleichung

$$SiO_2 + 2\ C + Ar = Si + 2\ CO + Ar$$

Das elementare Silizium wird als p-Silizium-Schicht 11 auf der Oberfläche 9 von geschmolzenem Blei als Substrat niedergeschlagen. Durch die Heizung 13 wird der Tiegel 18 mit dem Blei 9 auf 600 °C aufgeheizt. Die Siliziumschicht 11 wird als Band mit der konstanten Geschwindigkeit 15 von der Blei-Oberfläche 9 abgezogen. Das bei der Reduktion des $SiO_2$ entstehende CO wird ebenso wie das Argon aufgefangen und gespeichert.

Ausführungsbeispiel 6

In Fig 6 ist eine Silizium-Schicht-Solarzelle im Querschnitt dargestellt, deren p- und n-Siliziumschichten 11 und 10 nach einem Verfahren der Efindung hergestellt sind. Die p-Silizium-Schicht 11 ist durch Reduktion von sehr reinem $SiO_2$-Pulver (mit definiertem $B_2O_3$-Zusatz) und die n-Silizium-Schicht 10 durch Reduktion von sehr reinem $SiO_2$-Pulver (mit $As_2O_3$-Zusatz) in der Plasma-Zone eines Gas-Stromes aus Kohlenmonoxyd nach der Reaktionsgleichung erzeugt:

$$SiO_2 + 2\ CO = Si + 2\ CO_2$$

Die p-Silizium-Schicht 11 ist auf der Zinn-Schicht 19 niedergeschlagen. Die Zinn-Schicht 19 (welche 0,5 % Aluminium enthält) befindet sich auf der Oberfläche des Keramik-Substrates 9. Sie war beim Niederschlagen der Silizium-Schicht 11 flüssig. Die n-Silizium-Schicht 10 ist mit einer strukturierten Kontakt-Schicht 20 aus Zink versehen, an welche der Vorderseiten-Kontakt 22 der Solarzelle geschweißt ist.
Der Rückseiten-Kontakt 21 der Solarzelle ist an die Zinn-Schicht 19 angebracht. Die Solarzelle ist mit Hilfe eines Heiß-Preß-Prozesses mit einer lichtdurchlässigen Polycarbonat-Masse 23 umspritzt worden. Zur Erhöhung der Witterungsbeständigkeit ist die gesamte Oberfläche danach mit einer Plasma-gespritzten Aluminiumoxyd-Schicht 24 umgeben. Unter der Sonnenstrahlung 25 liegt die Fotospannung der Solarzelle zwischen den Kontakten 21 und 22.

Ausführungsbeispiel 7

In Fig 7 ist 7 ein Gehäuse mit quadratischem Querschnitt. Aus der Düse 26 fließt ein flächenhafter Wasserstrahl, der im Gehäuse 7 einen (den Querschnitt ausfüllenden) Wasservorhang 27 bildet. Gegen diesen Wasservorhang 27 bläst ein Wasserstoff-Gas-Plasma 3. Im Plasma 3 erfolgt die Reduktion von sehr feinem Quarzpulver nach der Reaktionsgleichung

$$2\ H_2 + SiO_2 = Si + 2\ H_2O$$

Das erzeugte Silizium wird mit dem Wasservorhang 27 in den Abfluß 28 gespült und durch Filterung des Wassers als Pulver gewonnen.

Ausführungsbeispiel 8

In Fig 8 ist 3 ein Plasma in einem Argon-Gas-Strahl, der mit Methan gemischt ist. Dieser gemischte Gas-Strahl ist mit Siliziumtetrachlorid beladen. Im Plasma erfolgt zunächst die Reaktion:

$$SiCl_4 + CH_4 + Ar = Si + 4\ HCl + C + Ar$$

Die Elemente Si und C reagieren unter geeigneten Bedingungen weiter zu Siliziumcarbid:

$$Si + C = SiC$$

Auf einem Silizium-Substrat 9, das durch die Heizung 13 auf 1200 °C aufgeheizt ist, wird das im Plasma 3 gebildete SiC als Schicht 29 niedergeschlagen. Das Substrat 9 befindet sich in einem Raum 8, der evakuiert wird.

Ausführungsbeispiel 9

In Fig 9 ist 16 der Spritz-Kopf eine Plasma-Spritz-Anlage. 1 ist ein Wasserstoff-Gas-Strom, in welchem zwischen der Kathode 4 und der Anode 5 ein Lichtbogen brennt, der das Plasma 3 erzeugt. Der Gasstrom 1 wird mit einem pulverförmigen Gemisch 2 aus $SiO_2$ und $MoO_3$ beladen. 17 ist die Wasserkühlung des Spritzkopfes 16. Im Plasma 3 wird nach der Gleichung

$$7\ H_2 + 2\ SiO_2 + MoO_3 = 2\ Si + 7\ H_2O + Mo$$

Silizium und Molybdän gebildet. Beide Elemente reagieren unter geeigneten Bedingungen im Plasma weiter zu Molybdändisilizid:

$$2\ Si + Mo = MoSi_2$$

Dieses $MoSi_2$ wird als Schicht 30 auf einem Eisenband 9 abgeschieden, welches mit der Geschwindigkeit 15 unter dem Plasma-Strahl 3 bewegt wird. Das Eisenband 9 ist durch die Heizung 13 im Vakuum 8 auf 1000 °C aufgeheizt.

Ausführungsbeispiel 10

Fig 10 zeigt im Querschnitt eine Anordnung gemäß der Erfindung mit einer Gas-stabilisierten Plasma-Schweiß-Anlage. Es bedeutet 1 einen Gas-Strahl, welcher zu 50 % aus Argon und zu 50 % aus Wasserstoff besteht. Die Kathode 4 ist aus p-leitendem Silizium. Sie erhitzt sich im Betrieb auf eine so hohe Temperatur, daß die Leitfähigkeit des Silizums sehr hoch wird (besser als Kohle). Zwischen der Kathode 4 und der Anode 5 brennt das Lichtbogen-Plasma 3. Die Anode 5 ist gleichzeitig das Substrat, auf dem die Silizium-Schicht 10 niedergeschlagen wird. In die Hochtemperatur-Zone des Plasmas 3 ist mit einem Ende der Quarzstab 31 eingebracht. Das eingebrachte Ende des Quarzstabes 31 schmilzt und verdampft. Der Silizium-Oxid-Dampf wird durch den Wasserstoff im Gas-Strahl 1 bei Temperaturen >> 2000 °C im Plasma zu Silizium reduziert. Das durch diese Reduktion gebildete Silizium wird mit dem Plasma- und Gas-Strahl 1 auf die Anode 5 aus Eisenblech transportiert und dort abgeschieden. Die Anode 5 bewegt sich mit der Geschwindigkeit 34 und nimmt deshalb keine für die Kondensation des Siliziums zu hohe Temperatur an. 7 ist ein Gehäuse für den Gas-Strahl 1. Um den Einfluß des

Luft-Sauerstoffs aus der Umgebung möglichst weitgehend auszuschalten, ist der Gas-Strahl 1 mit einem brennenden Schutzgas-Mantel 32 aus Propan-Gas umgeben. 33 ist das Gehäuse des Schutzgas-Mantels 32 im Querschnitt. Die auf dem Eisenblech 5 als Anode abgeschiedene polikristalline Silizium-Schicht 10 wird zur Herstellung einer Silizium-Solarzelle benutzt.

Ausführungsbeispiel 11

Fig 11 zeigt im Querschnitt eine Prinzipskizze gemäß der Erfindung mit einer Wasser-stabilisierten Plasma-Spritz-Anlage. 1 ist ein Wasserstoff-Gas-Strahl. 4 ist eine einkristalline Silizium-Kathode, die in dem wassergekühlten Kathoden-Anschluß 38 gehaltert ist. 5 ist eine um die Achse 39 rotierende Anode. 39 ist gleichzeitig die Stromzuführung der Anode 5. Sie hat die Form einer Scheibe und besteht ebenfalls aus einkristallinem Silizium. 3 ist das Plasma, das sich von der Kathode 4 bis zur Anode 5 hinzieht. Das Plasma 3 ist in der Wasser-Kammer 36 von Wasser 37 umgeben und besteht aus den $H^+$-Ionen des Gas-Strahles 1 und den $H^+$- und $O^{--}$-Ionen aus thermisch dissoziiertem Wasser 37. In die heiße Rekombinationszone des Plasmas 3 hinter der Anode 5 ist ein Stab 31 aus gepreßtem $SiO_2$ mit einem Ende eingebracht. Das $SiO_2$ schmilzt und verdampft im Plasma 3 und der Silizium-Oxid-Dampf wird durch den im Überschuß vorhandenen Wasserstoff zu Silizium reduziert. Das Silzium wird durch den Gas-Strahl 1 aus dem Plasma wegtransportiert und schlägt sich als Silizium-Schicht 10 auf dem metallisierten Keramik-Substrat 9 nieder. Das Substrat 9 wird mechanisch mit der Geschwindigkeit 35 bewegt, so daß die niedergeschlagene Silizium-Schicht 10 gleichmäßig dick aufgetragen wird. 7 ist ein isolierendes Gehäuse der Plasma-Spritz-Anlage.

Die ganze Anordnung befindet sich in einer Kammer 40, die eine Sauerstoff-freie Atmosphäre besitzt. Die Vorrichtungen für den Abtransport des Wasserdampfes und des überschüssigen Wasserstoffs aus der Kammer 40 heraus sind Fig 11 ebenso nicht eingezeichnet wie der Zu- und Ab-Fluß des Wassers 37 in und aus der Wasserkammer 36.

Licentia Patent-Verwaltungs-G.m.b.H.
Theodor-Stern-Kai 1, 6000 Frankfurt 70

Heilbronn, den 10.02.81
SE2-HN-Ma/goe

Patentansprüche

1) Verfahren zur Herstellung von Silizium, dadurch gekennzeichnet, daß ein Gas-Strom (1) vorgesehen ist, daß in diesem Gas-Strom (1) ein Plasma (3) erzeugt wird, daß Mittel vorgesehen sind, durch welche der Gas-Strom (1) mindestens mit einer Siliziumverbindung (2) beladen wird, daß im Plasma (3) des Gas-Stromes (1) die Siliziumverbindung (2) zu Silizium zerlegt oder reduziert wird, und daß das Silizium zusammen mit den Reaktionsprodukten durch den Gas-Strom (1) aus dem Plasma (3) heraustransportiert wird.

2) Verfahren nach Anspruch 1, dadurch gekennzeichnet, daß das Plasma (3) durch elektrischen Gleichstrom oder Wechselstrom erzeugt wird.

3) Verfahren nach Anspruch 1 dadurch gekennzeichnet, daß das Plasma (3) durch Absorption intensiver elektromagnetischer oder ionisierender Strahlung im Gas-Strom (1) erzeugt wird.

4) Verfahren nach einem der vorhergehenden Ansprüche, dadurch gekennzeichnet, daß das im Plasma (3) erzeugte Silizium auf einem Substrat (9) niedergeschlagen wird.

5) Verfahren nach einem der vorhergehenden Ansprüche, dadurch gekennzeichnet, daß eine Plasma-Spritz-Anlage mit Gas-stabilisiertem Plasma (3) zur Herstellung von Silizium verwendet wird.

6) Verfahren nach einem der vorhergehenden Ansprüche, dadurch gekennzeichnet, daß eine Plasma-Spritz-Anlage mit Wasser-stabilisiertem Plasma (3) verwendet wird.

7) Verfahren nach einem der vorhergehenden Ansprüche, dadurch gekennzeichnet, daß die Silizium verbindung (2) eine Sauerstoff-freie Siliziumverbindung wie z. B. $SiH_4$ $SiCl_4$, $SiHCl_3$, $SiH_2Cl$ u. a. ist.

8) Verfahren nach einem der vorhergehenden Ansprüche, dadurch gekennzeichnet, daß die Siliziumverbindung (2) eine Sauerstoff-haltige Siliziumverbindung wie z. B. $SiO_2$, ein silicat oder Silizium-organische Verbindung ist.

9) Verfahren nach einem der vorhergehenden Ansprüche, dadurch gekennzeichnet, daß der Gas-Strom (1) zusätzlich mit einem Dotierstoff aus der dritten oder fünften Gruppe des Periodischen Systems beladen ist.

10) Verfahren nach einem der vorhergehenden Ansprüche, dadurch gekennzeichnet, daß der Gas-Strom (1) zusätzlich noch mit Silizium-Pulverteilchen beladen ist.

11) Verfahren nach einem der vorhergehenden Ansprüche, dadurch gekennzeichnet, daß der Gas-Strom (1) zusätzlih noch mit Kohlenstoff-Pulverteilchen beladen ist.

12) Verfahren nach einem der vorhergehenden Ansprüche, dadurch gekennzeichnet, daß der Gas-Strom (1) aus Wasserstoff besteht und daß als Siliziumverbindung (2) Siliziumchlorid verwendet wird.

13) Verfahren nach einem der vorhergehenden Ansprüche, dadurch gekennzeichnet, daß der Gas-Strom (1) aus Edelgas oder Wasserstoff besteht und daß als Siliziumverbindung (2) Siliziumwasserstoff verwendet wird.

14) Verfahren nach einem der vorhergehenden Ansprüche, dadurch gekennzeichnet, daß der Gas-Strom (1) aus Wasserstoff und die Siliziumverbindung (2) aus $SiO_2$ besteht.

15) Verfahren nach einem der vorhergehenden Ansprüche, dadurch gekennzeichnet, daß der Gas-Strom (1) aus einem Gemisch von Edelgas oder Wasserstoff mit einer Kohlenwassserstoffverbindung und die Siliziumverbindung (2) aus $SiO_2$ besteht.

16) Verfahren nach einem der vorhergehenden Ansprüche, dadurch gekennzeichnet, daß der Gas-Strom (1) aus Wasserstoff oder Edelgas oder einem Gemisch dieser Gase besteht, und daß der Gas-Strom (1) mit $SiO_2$-Pulverteilchen (2) und zusätzlich mit Kohlenstoff-Pulverteilchen beladen wird.

17) Verfahren nach einem der vorhergehenden Ansprüche, dadurch gekennzeichnet, daß das Silizium auf einer metallisch leitenden Fläche (9) wie z. B. auf einer Metall-Oberfläche oder auf metallisch leitenden Schicht niedergeschlagen wird.

18) Verfahren nach einem der vorhergehenden Ansprüche, dadurch gekennzeichnet, daß das Silizium auf einer Isolatorfläche (9) niedergeschlagen wird.

19) Verfahren nach einem der vorhergehenden Ansprüche, dadurch gekennzeichnet, daß das Silizium auf einer Flüssigkeits-Oberfläche (9) niedergeschlagen wird, die mit dem Silizium chemisch nicht reagiert, wie z. B. flüssiges $MgCl_2$ oder Blei bei 750 °C.

20) Verfahren nach einem der vorhergehenden Ansprüche, dadurch gekennzeichnet, daß das Silizium auf einem erhitzten Träger (9) - z. B. Graphit oder Keramik auf 1000 °C - niedergeschlagen wird, der mit einem dünnen Flüssigkeitsfilm (12), welcher mit dem Silizium nicht reagiert - z. B. einem NaF-Film oder einem Zinn-Film - überzogen ist.

21) Verfahren nach einem der vorhergehenden Ansprüche, dadurch gekennzeichnet, daß das im Plasma (3) gebildete Silizium unter Bildung eines Silizids weiterreagiert.

22) Verfahren nach einem der vorhergehenden Ansprüche, dadurch gekennzeichnet, daß ein Plasma (3) in einem nichtoxidierenden Gas-Strahl (1) vorgesehen ist, daß in das Plasma (3) ein Formkörper teilweise eingebracht ist, daß der Formkörper (31) aus Silizium-Oxid besteht oder Silizium-Oxid enthält, daß im Plasma (3) das Silizium-Oxid zu Silizium reduzeirt wird, und daß das erzeugte Silizium im Gas-Strahl (1) wegtransportiert wird.

23) Verfahren nach einem der vorhergehenden Ansprüche, dadurch gekennzeichnet, daß als Plasma (3) das Lichtbogen-Plasma einer Gas-stabilisierten Plasma-Spritz-Anlage oder Plasma-Schweiß-Anlage verwendet wird.

24) Verfahren nach einem der vorhergehenden Ansprüche, dadurch gekennzeichnet, daß als Plasma (3) das Lichtbogen-Plasma einer wasserstabilisierten Plasma-Spritz-Anlage verwendet wird.

25) Verfahren nach einem der vorhergehenden Ansprüche, dadurch gekennzeichnet, daß mindestens eine der beiden Elektroden (4, 5) der Plasma-Spritzanlage aus Silizium besteht.

26) Verfahren nach einem der vorhergehenden Ansprüche, dadurch gekennzeichnet, daß für die Elektroden (4, 5) der Plasma-Spritz-Anlage dotiertes Silizium verwendet wird, und daß das im Plasma (3) durch Reduktion erzeugte Silizium und das Silizium der Elektroden (4, 5) den gleichen Leitfähigkeitscharakter haben.

27) Verfahren nach einem der vorhergehenden Ansprüche, dadurch gekennzeichnet, daß das von den Elektroden (4, 5) aus dotiertem Silizium abdampfende Material zur Dotierung des im Plasma (3) erzeugten Siliziums verwendet wird.

28) Verfahren nach einem der vorhergehenden Ansprüche, dadurch gekennzeichnet, daß der Formkörper (31) aus Silizium-Oxid ein Quarzstab, ein Quarz-Faden oder ein Quarz-Rohr ist, und daß er so in die Hochtemperaturzone des Plasmas (3) eingeführt wird, daß das eingeführte Ende kontinuierlich abgeschmolzen, verdampft und zu Silizium reduziert wird.

29) Verfahren nach einem der vorhergehenden Ansprüche, dadurch gekennzeichnet, daß der Formkörper (31) ein Stab oder ein Rohr ist, welches aus gepreßtem oder gesintertem SiO- oder $SiO_2$-Pulver hergestellt wird.

30) Verfahren nach einem der vorhergehenden Ansprüche, dadurch gekennzeichnet, daß der in das Plasma (3) eingeführte Formkörper (31) aus einem Pulvergemisch aus Kohlenstoff oder einer Kohlenstoffverbindung mit Quarz hergestellt wird.

31) Verfahren nach einem der vorhergehenden Ansprüche, dadurch gekennzeichnet, daß dem Silizium-Oxid zur Dotierung des Siliziums eine kleine Menge eines Elementes oder eine Verbindung eines Elementes aus der dritten oder fünften Gruppe des Periodischen Systems beigemengt wird.

32) Verfahren nach einem der vorhergehenden Ansprüche, dadurch gekennzeichnet, daß das Plasma (3) in einem nichtoxydierenden Gas-Strahl (1) aus Z. B. Edelgas, Wasserstoff, Stickstoff, Kohlenoxid, Kohlenwasserstoff, Halogenwasserstoff, Ammoniak, Schwefelwasserstoff, Wasserdampf oder aus einem Gemisch dieser Gase erzeugt ist.

33) Verfahren nach einem der vorhergehenden Ansprüche, dadurch gekennzeichnet, daß der Gas-Strahl (1) mit dem Plasma (3) eingehüllt ist von einem brennenden oder nichtbrennenden Schutzgas-Mantel (32) aus z. B. Kohlenwasserstoff- oder Wasserstoff-Gas oder z. B. aus Edelgas oder Stickstoff.

34) Verfahren nach einem der vorhergehenden Ansprüche, dadurch gekennzeichnet, daß das Silizium in einer Sauerstoff-freien Atmosphäre abgeschieden oder niedergeschlagen wird.

35) Verfahren nach einem der vorhergehenden Ansprüche, dadurch gekennzeichnet, daß der Gas-Strahl (1) mit dem Plasma (3) in eine Unterdruck-Kammer strömt, in der Unterdruck oder Vakuum herrscht.

36) Verfahren nach einem der vorhergehenden Ansprüche, dadurch gekennzeichnet, daß das mit Hilfe des Plasmas (3) erzeugte Silizium auf einem Substrat (9) in Form einer polikristallinen oder einkristallinen Silizium-Schicht (10) niedergeschlagen wird.

37) Verwendung der Verfahren nach einem der vorhergehenden Ansprüche zur Herstellung von einkristallienem oder polikristallinem Silizium.

38) Verwendung des Verfahrens nach einem der vorhergehenden Ansprüche, zur Herstellung von einkristallinen oder polikristallinen Silizium-Platten oder -Schichten.

39) Verwendung des Verfahrens nach einem der vorhergehenden Ansprüche zur Herstellung von Silizium-Solarzellen.

40) Verwendung des Verfahrens nach einem der vorhergehenden Ansprüche zur Herstellung von Siliziumbauelementen unter Bildung von p-Zonen, n-Zonen und gegebenenfalls p/n-Übergängen.

41) Verwendung des Verfahrens der nach einem der vorhergehenden Ansprüche zur Herstellung von Siliziumpulver.

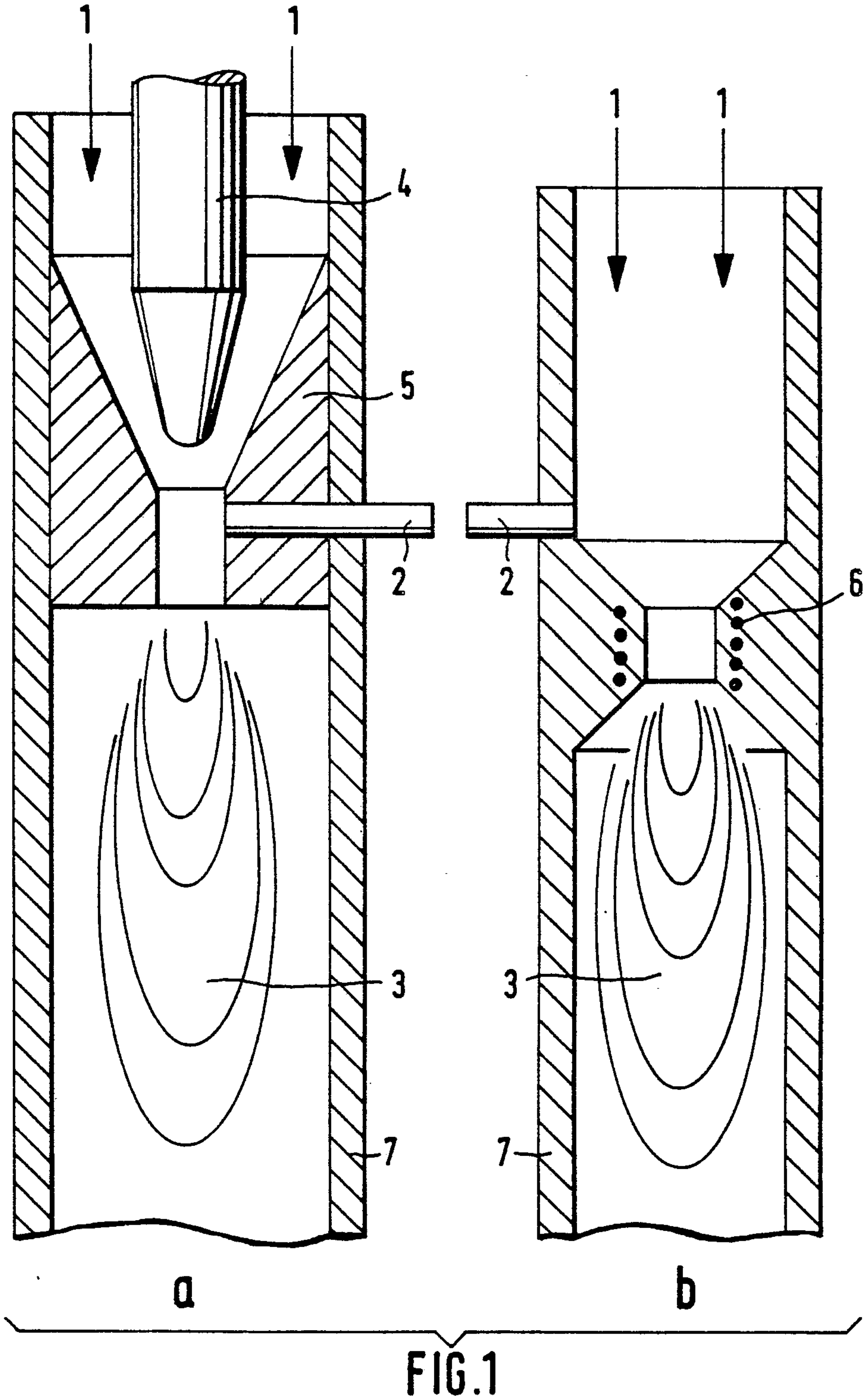


FIG.1

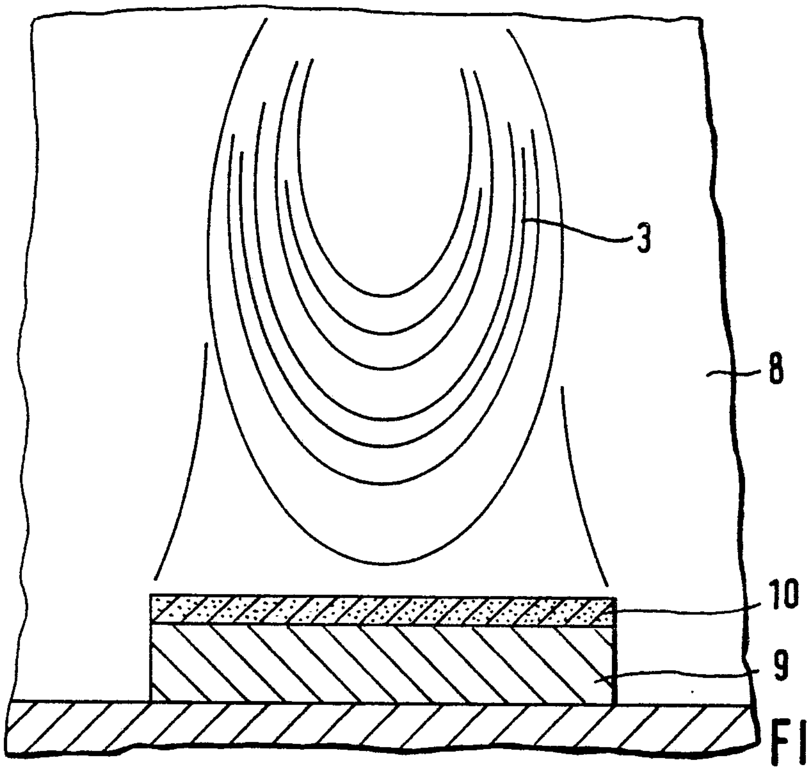


FIG. 2

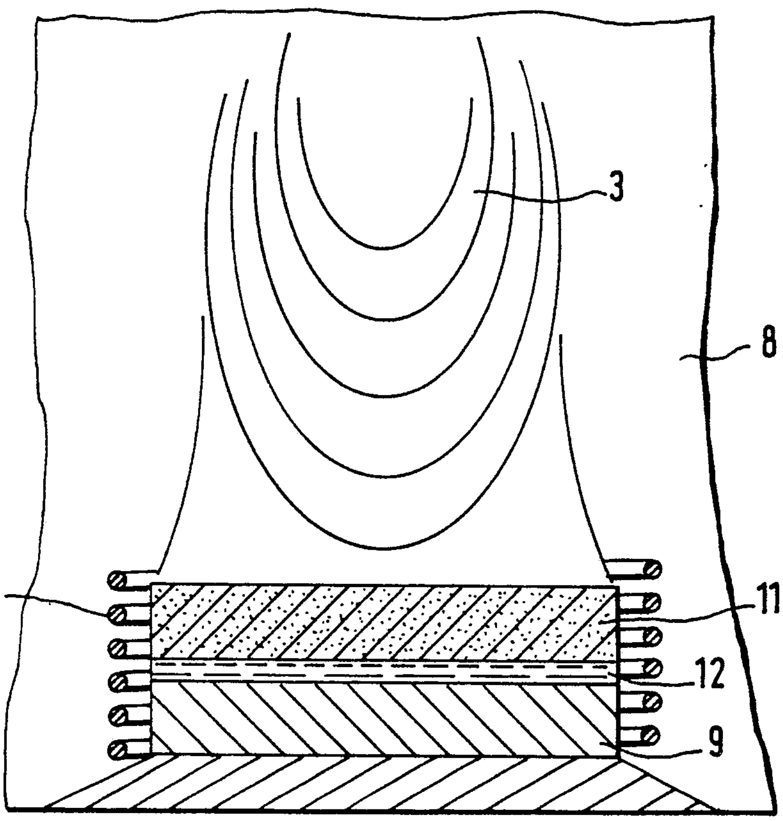


FIG. 3

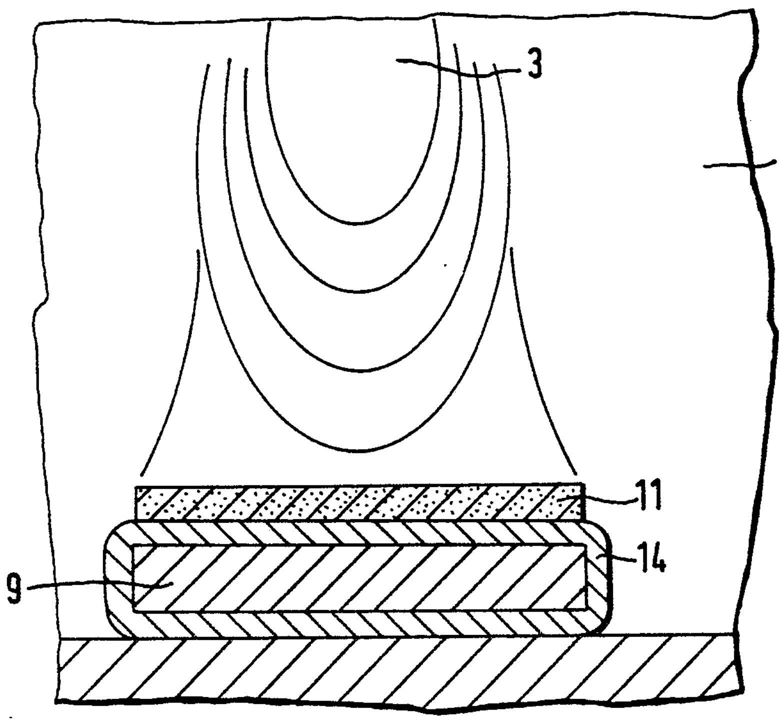


FIG.4

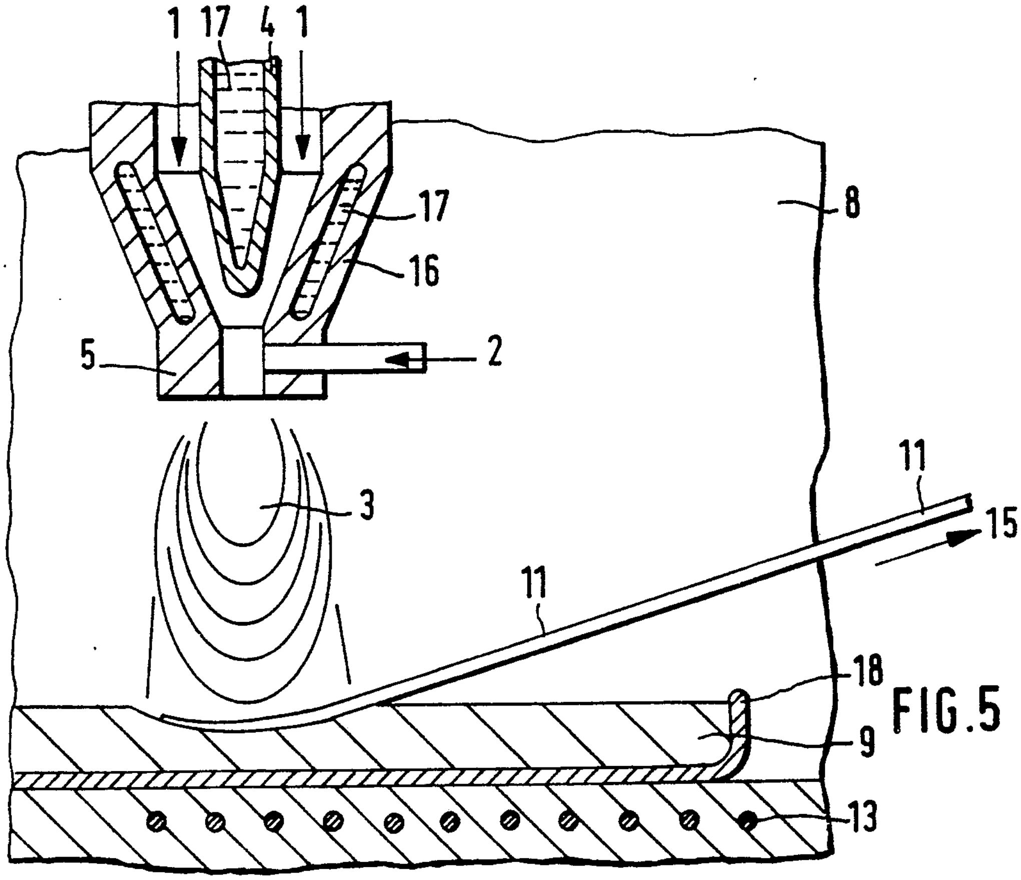


FIG.5

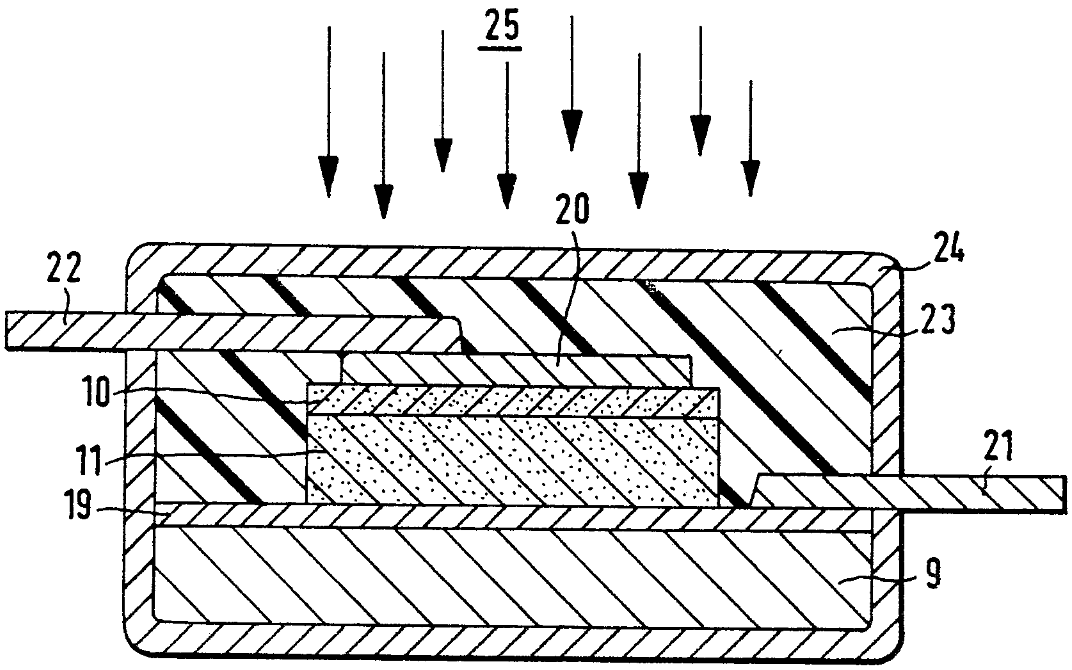


FIG.6

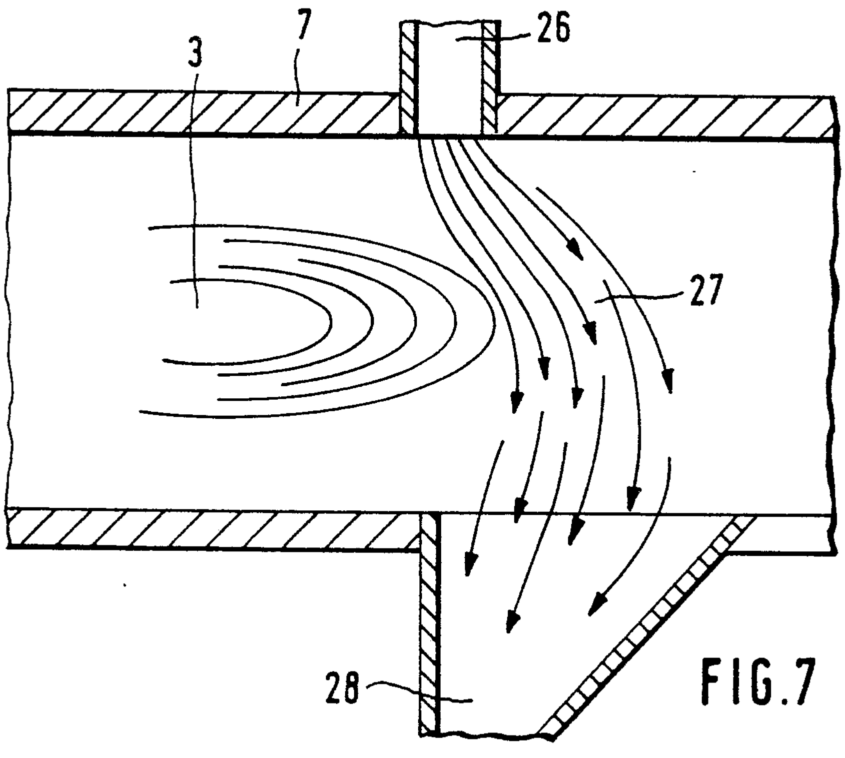


FIG.7

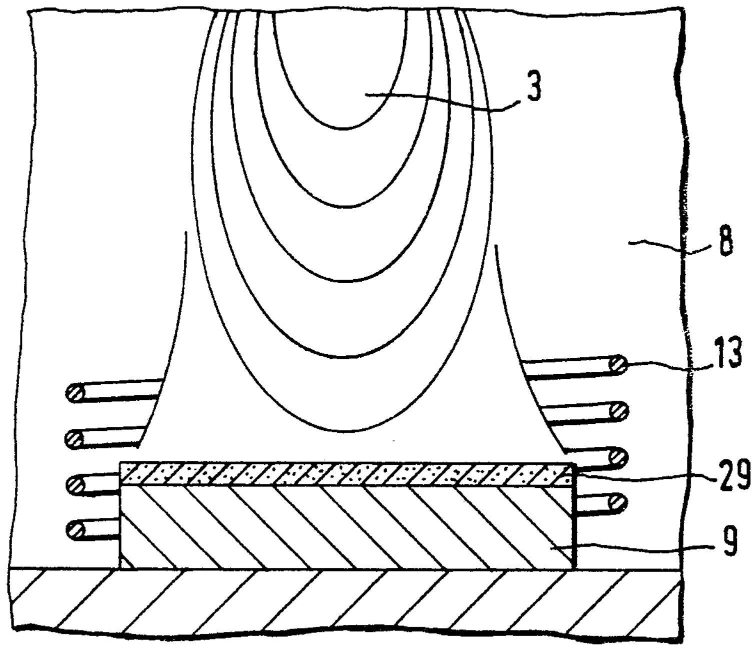


FIG.8

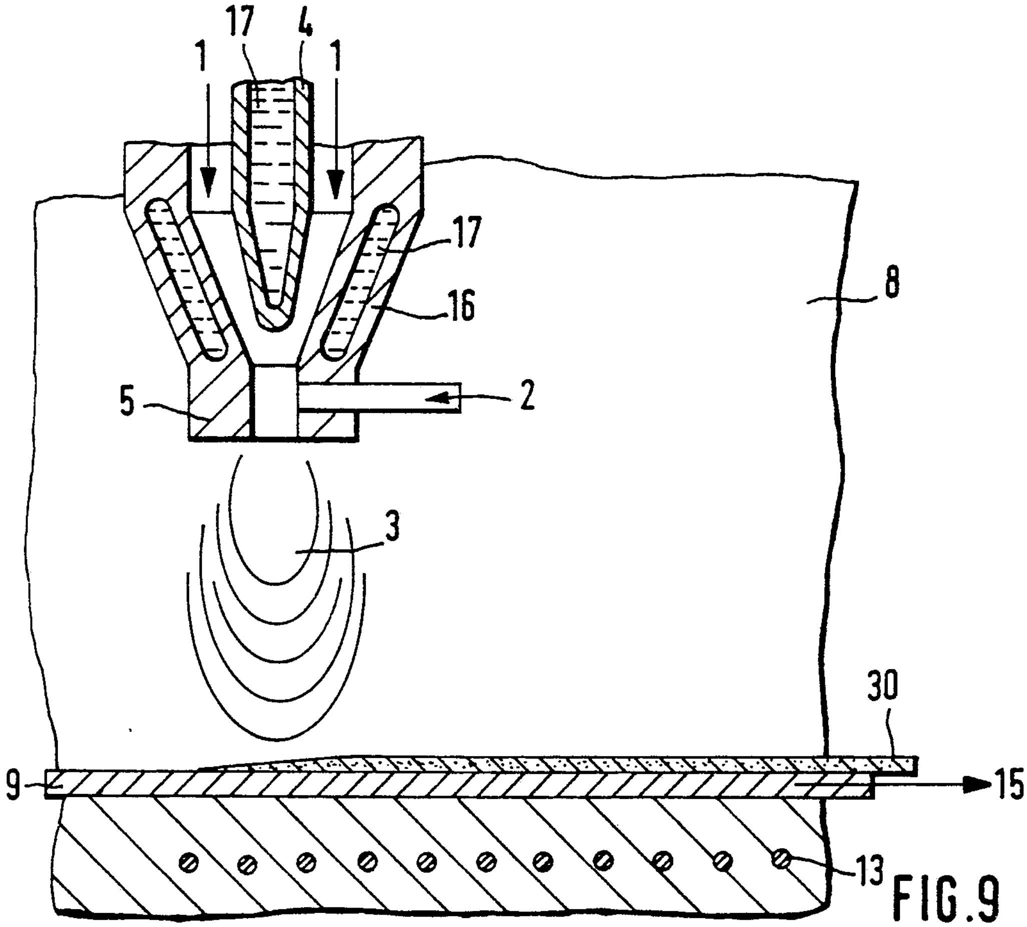


FIG.9

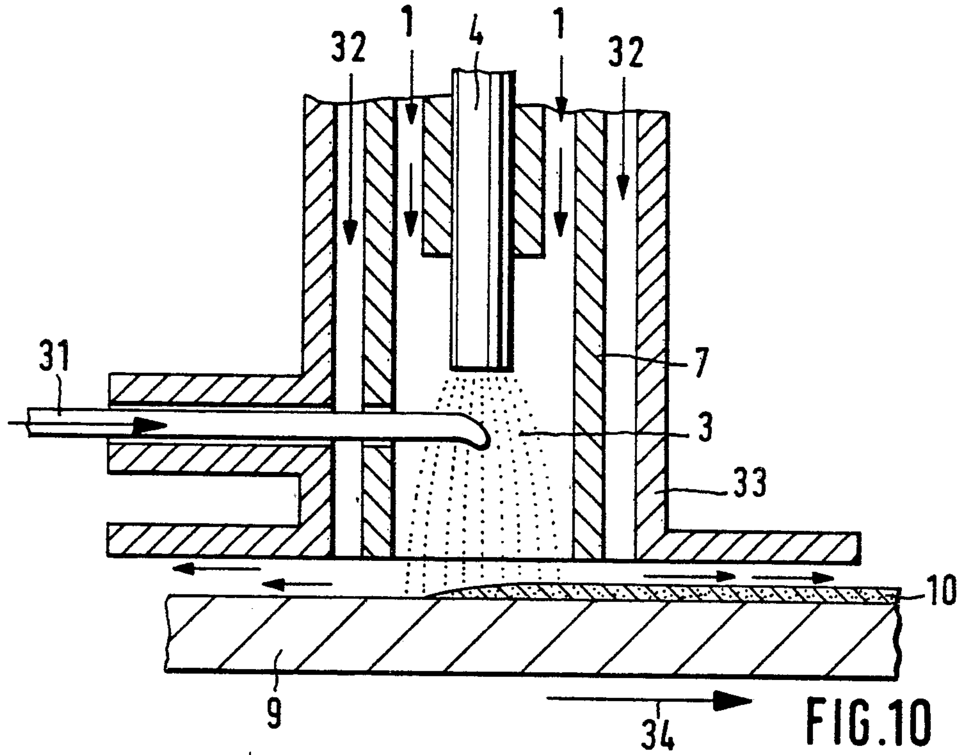


FIG.10

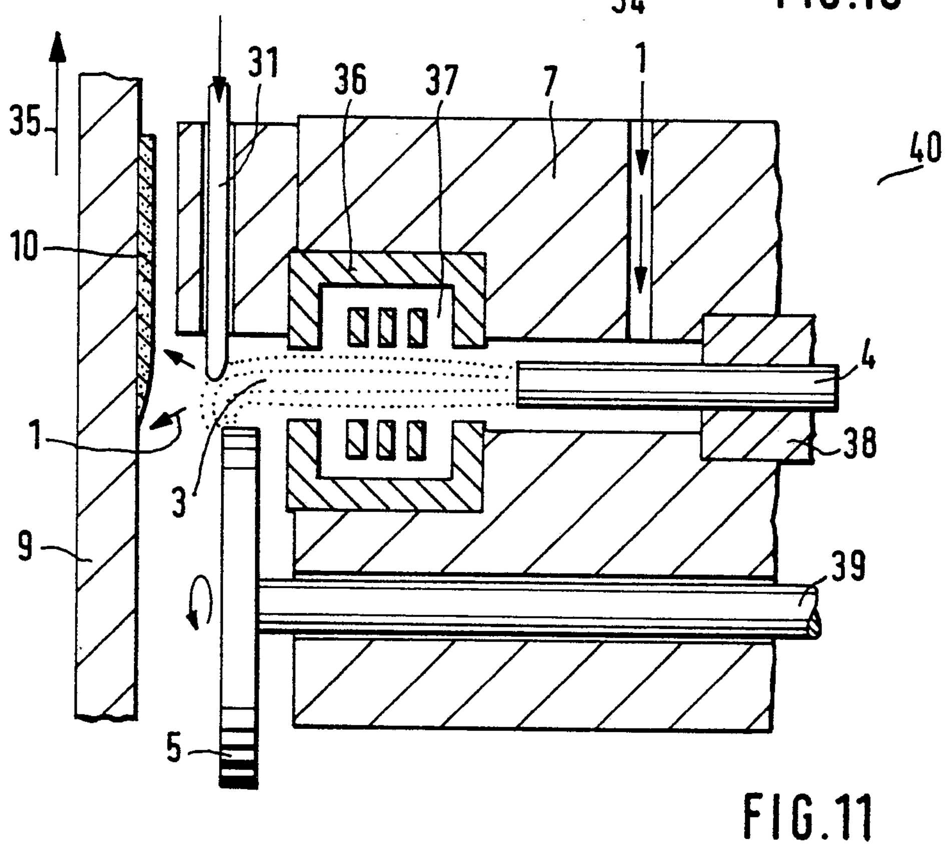


FIG.11

Europäisches Patentamt

# EUROPÄISCHER RECHERCHENBERICHT

0039417 Nummer der Anmeldung

EP 81 10 2605.3

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | SOLID STATE TECHNOLOGY, Band 23, Nr. 4, April 1980 Washington K.R. SARMA "Plasma Deposited Polycrystalline Silicon Films" Seiten 143 bis 146 -- | 1-3,4, 7,9, 12,13 |
| X | DE - A1 - 2 816 234 (WESTINGHOUSE) * Ansprüche 1 bis 5 * -- | 1,7,9 |
| D | US - A- 4 003 770 (R.J. JANOWIECKI et al.) -- | |
| P | DE - A1 - 2 924 584 (S. STRÄMKE et al.) -- | |
| A | DE - A1 - 2 922 468 (KEMA NORD) * Ansprüche 1, 6 * -- | 8 |
| A | DE -A1 - 2 344 319 (SIEMENS) ---- | |

KLASSIFIKATION DER ANMELDUNG (Int. Cl.³)

C 01 B 33/02

RECHERCHIERTE SACHGEBIETE (Int. Cl.³)

C 01 B 33/00
C 30 B 23/00
C 30 B 25/00
C 30 B 29/00
H 01 L 21/00

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 31-07-1981 | KESTEN |